# EUROPÄISCHE PATENTSCHRIFT

(11) **EP 1 668 658 B1**
(45) Veröffentlichungstag und Bekanntmachung des Hinweises auf die Patenterteilung: **20.10.2010**
(21) Anmeldenummer: 04763888.7
(22) Anmeldetag: 06.08.2004
(51) Int. Cl.: H01H 5/02

(54) **SCHALTEINHEIT MIT RASTFUNKTION FÜR EIN WERKZEUG**
SWITCH UNIT WITH INDEXING FUNCTION FOR A TOOL
UNITE DE COMMUTATION COMPORTANT DES MOYENS D'INDEXATION POUT UN OUTIL

(30) Priorität: 23.09.2003 DE 10344250
(43) Veröffentlichungstag der Anmeldung: 14.06.2006
(73) Patentinhaber: Bosch Rexroth AG, 70184 Stuttgart (DE)
(72) Erfinder: WIELER, Michael, 73614 Schorndorf (DE); KURZ, Jürgen, 73557 Mutlangen (DE); SCHNEIDER, Jörg, 74427 Fichtenberg (DE)
(86) Internationale Anmeldenummer: PCT/EP2004/008858
(87) Internationale Veröffentlichungsnummer: WO 2005/041229

(56) Entgegenhaltungen:
- DE-A- 19 749 330
- DE-U- 20 220 379
- US-A- 3 407 370
- US-A- 6 003 367
- US-A1- 2002 056 321

## Beschreibung

### Technisches Gebiet

Die Erfindung betrifft eine Schalteinheit mit kombinierter Schalt- und Rastfunktion zur Steuerung von Industriewerkaeugen, insbesondere Handgeräte, wie z.B. Schrauber und Bohrer.

### Stand der Technik

Anforderungen an die Performance von Industriewerkzeugen werden immer höher, insbesondere wird das Verhältnis Kosten zu Nutzen immer kritischer betrachtet. In allen Industrien kommen die Gesamtkosten der Fertigungsgeräte und nicht nur der Kaufpreis in Betracht. Wartungsaufwand, Ersatzteilkosten, Ausfallrate, usw. bestimmen zusammen gerechnet die Lebenskosten des Geräts. Natürlich spielt Produktivität auch eine große Rolle. Geräte die gern benutzt werden und einfach zu bedienen sind, tragen zu einer erhöhten Produktivität bei. Die Benutzerfreundlichkeit eines Geräts ist deswegen ein wesentliches Unterscheidungsmerkmal für die Lieferanten von Industriewerkzeugen. Die Bedienelemente eines Geräts sind von größerer Bedeutung, weil sie öfters betätigt/benutzt werden. Ein elektrischer oder mechanischer Fehler in solch einem Kleinteil kann das Gerät zum Stillstand bringen. Die Bedienelemente (oder Schalteinheiten), darunter Schalter, Knöpfe, und/oder Dreh- oder Schiebeelemente müssen robust, gut bedienbar, eindeutig einstellbar und so weit wie möglich verschleißfrei sein.

In den auf dem Markt befindlichen Geräten werden Bedienelemente wie Schalter und Drehknöpfe mit einem mechanischen Rastmoment versehen, um die Bedienbarkeit und Eindeutigkeit der Schaltung zu verbessern. Das Rastmoment wird in der Regel durch Reib- oder Federelemente generiert und die elektrische Schaltfunktion durch einen elektromechanischen Schalter realisiert. Die Lebensdauer dieser Art von Bedienelementen ist durch ihre mechanischen Eigenschaften begrenzt, und ihr Verschleiß führt zu einer Reduzierung der MTBF (Mean Time Between Failures) des Geräts. Die US-A-2002/0056321 offenbart eine magnetische Rasteinrichtung für Drehschalter.

### Darstellung der Erfindung

Der Erfindung liegt somit die Aufgabe zugrunde eine verbesserte Schalteinheit mit kombinierter Schalt- und Rastfunktion zur Steuerung von Industrie-Werkzeugen zur Verfügung zu stellen und gleichzeitig die Nachteile herkömmlicher Lösungen zu vermeiden. Diese Aufgaben werden erfindungsgemäß durch die Schalteinheit gemäß Anspruch 1 gelöst. Weitere vorteilhafte Ausgestaltungen der Erfindung finden sich in den Unteransprüchen.

Die Schalteinheit mit kombinierter Schalt- und Rastfunktion zur Steuerung von Industriewerkzeugen hat sowohl eine Rast- als auch eine Schaltfunktion, wobei beide Funktionen auf magnetischer Basis erfolgen. Die Schalteinheit besteht aus zwei gegenüberliegenden Reihen von Magneten und jede Reihe besteht aus mindestens zwei Magneten. Der Abstand zwischen den einhüllenden, der sich gegenüberliegenden Seiten der Magnetreihen ist im wesentlichen konstant, wobei die Reihen gegeneinander in Richtung der Reihenerstreckung relativ beweglich sind. Des weiteren ist der Abstand zwischen den benachbarten Magneten einer Reihe im wesentlichen konstant und in einer der Magnetreihen ist mindestens ein Magnetfelddetektor vorgesehen. Die Schalteinheit ist somit fast verschleißfrei, ihre Eigenschaften sind nicht zeitabhängig und die dafür vorgesehenen Wartungsintervalle sind nur von der Lagerung des Drehknopfs abhängig. Die Schalteinheit ist deswegen sehr robust. In einer Reihe von Magneten ist ein Magnetfelddetektor vorgesehen, wobei der Detektor einen Magneten einer Reihenfolge ersetzt und zwei benachbarte Magnete aufweist. Weiter entspricht der Abstand zwischen dem Detektor und jedem der zwei Magneten näherungsweise dem Abstand oder einer Vervielfachung des Abstands zwischen den in der gegenüberliegenden Reihe montierten Magneten. Die dem Detektor benachbarten Magnete sind so montiert, dass die sich gegenüberliegenden Seiten unterschiedliche Magnetpole aufweisen. Vorteile dieser Bauform liegen, bedingt durch die einfache Geometrie der Magnetenreihen darin, dass die Magnete sowohl Rast- als auch Schaltfunktionen ausführen. Die Bauform hat den Vorteil, dass der Magnet dessen Magnetfeld vom Detektor detektiert wird, dem Detektor im eingerasteten Zustand immer direkt gegenüberliegt. Somit gewährleistet die Geometrie ein konsistentes und zuverlässiges Verhalten der Schalteinheit. Vorteilhafterweise sind die Magnete auch so angeordnet (magnetisiert), dass unabhängig von der Einstellung der Schalteinheit ein geschlossener Magnetflusskreis vorhanden ist, d.h. der Streufluss wird minimiert.

Vorteilhafterweise wird ein Hall-Effekt-Sensor als Detektor verwendet, weil er nicht verschleißbehaftet ist und sehr klein gebaut werden kann. Er ist von der Bauform her deswegen sehr flexibel. Er ist auch als Standardprodukt verfügbar und liefert ein 1-Bit-Ausgangssignal, das ohne Anpassung oder komplizierte Signalverarbeitung eine Einstellung der Drehrichtung eines Handgeräts erlaubt

In einer weiteren vorteilhaften Ausführungsform ist die Schalteinheit ein Drehschalter der zwei Schaltzustände aufweist, die mit den zwei Drehrichtungen eines Handgeräts korrespondieren. Um die Schalteinheit kompakt zu halten und die Effizienz der Magnete zu erhöhen, sind die Magnete an ihren einander abgewandten Seiten mit einem ferromagnetischen Schild zu versehen. Dieses Schild minimiert die Streuflussveduste und erhöht dadurch den effektiven Magnetfluss des Schaltkreises.

### Kurze Beschreibung der Zeichnungen

Die Erfindung wird nachfolgend anhand von Ausfuhrungsbeispielen im Zusammenhang mit den Zeichnungen näher erläutert. Es zeigen:
- Figur 1: eine schematische Darstellung des Schaltzustandes "Links" einer erfindungsgemäßen Schalteinheit.
- Figur 2: eine schematische Darstellung des Schaltzustandes "Rechts" einer erfindungsgemäßen Schalteinheit.
- Figur 3: einen Querschnitt eines Drehschalters gemäß der Erfindung.

In den Figuren sind nur die für das Verständnis der Erfindung wesentlichen Elemente und Bauteile in schematisierter Darstellung wiedergegeben.

Gleiche oder gleichwirkende Bauteile sind in den Figuren weitgehend mit gleichen Bezugszeichen gekennzeichnet.

### Wege zur Ausführung der Erfindung

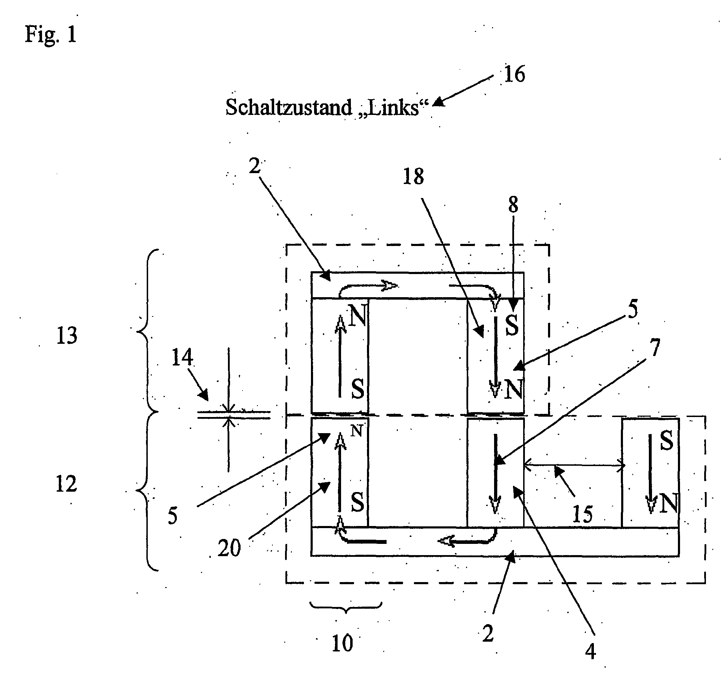

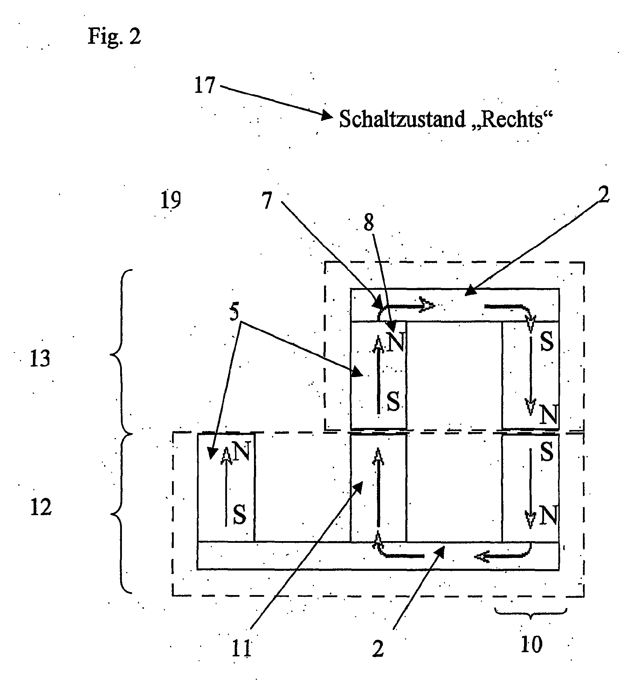

In den Figuren 1, 2 und 3 sind schematische Darstellungen bevorzugter Formen der Erfindung gezeigt. Fig. 1 und 2 zeigen eine magnetische Schaltung einschließlich zweier Magnetreihen 12, 13, zwei den Magneten zugeordnete ferromagnetische Stahlringe 2, und einen Detektor 4, 11. Erfindungsgemäß ist die Magnetreihe 13 der Reihe 12 gegenüber relativ beweglich, d.h., dass die Reihe 12 fest montiert ist, während die Reihe 13 in eine linke bzw. rechte Richtung verschoben werden kann. Der Abstand zwischen der Reihe 14 wird auch erfindungsgemäß mechanisch fixiert. Die Art und Weise der Fixierung ist aber in den schematischen Figuren 1 und 2 nicht gezeigt und hängt von der Ausführungsform der Schalteinheit ab.

Der Detektor 4, 11 muss erfindungsgemäß immer einen gegenüberliegenden Magneten 18 aufweisen. Dies führt dazu, dass die Schaltung, wie gezeigt, nur zwei Zustände annehmen kann. Die zwei Zustände sind in den Figuren als "Links" 16 und "Rechts" 17 bezeichnet.

Wenn die bewegliche Reihe 13 als die Aktivreihe bezeichnet wird, dann sind zwei Magnete 18, 19 aktiv und an der Schaltung/Rastung beteiligt. In Fig. 1 sind alle an der magnetischen Schaltung beteiligten Magnete 5 wie folgt angeordnet. Der magnetische Fluss 7 aus der Magnetreihe 13 fließt durch den Detektor 4, durch den Stahlring 2, durch den Magneten 20 und wieder in die gegenüberliegende Reihe 13 zurück Die Flussrichtung wird vom Hall-Sensor 4 detektiert und der Ausgang des Sensors in den korrespondierenden Zustand geschaltet. Die sehr hohe Permeabilität der ferromagnetischen Stahlringe 2 sorgt dafür, dass fast der gesamte magnetische Fluss 7 durch den Detektor 4 fließt und den Detektor gleichzeitig gegen externen magnetischen Streufluss abschirmt.

Die zwei eingerasteten Magnete 19, 20 sorgen dafür, dass die Position des den Detektor schaltenden Magneten 18 der beweglichen Magnetreihe 13, bezogen auf die gegenüberliegende Reihe 12 unter normalen Arbeitsbedingungen konstant bleibt, d.h., dass die im Betrieb zu erwartenden Vibrationen und Stöße den Zustand des Sensorausgangs nicht beeinflussen. Wenn die Magnetreihe 13 der Reihe 12 gegenüber verschoben wird, z.B. von links 16 nach rechts 17, dann muss die Kraft ausreichen, um das Rastmoment des eingerasteten Magneten 19 zu überwinden. Sobald das Rastmoment überwunden ist, lässt sich die Magnetreihe 13 mit minimalem Aufwand nach rechts bewegen, bis die zwei Magnete 19 sich anziehen und einrasten. Wenn die Magnetreihe 13 im Schaltzustand "Rechts" 17 verschoben wird, kehrt die Flussrichtung durch den Hall-Sensor um und dadurch schaltet sich der Ausgang des Sensors auch dementsprechend um. Es können Ferritmagnete oder selten Erdmagnete eingesetzt werden, je nach Schaltergröße, erforderlichem Rastmoment und gewünschtem Preis/LeistungsVerhältnis.

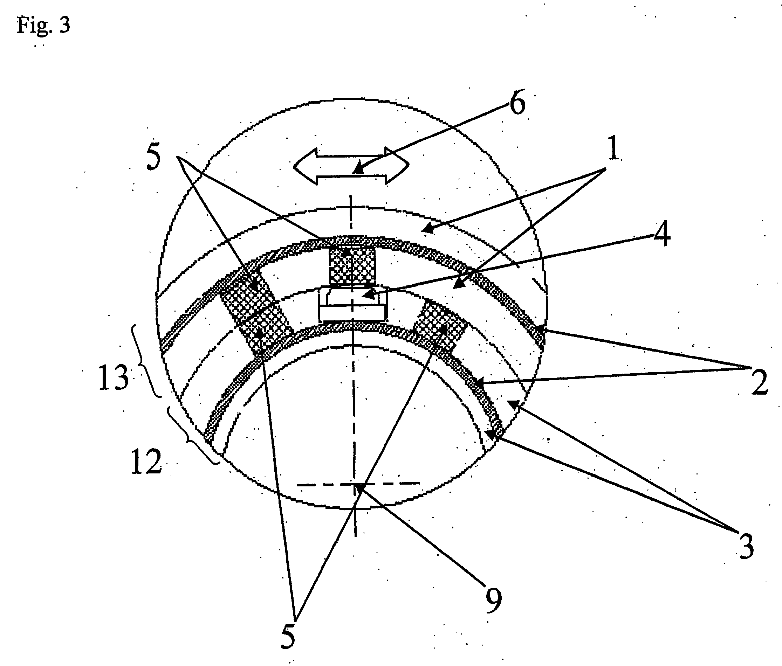

Figur 3 zeigt einen Ausschnitt des Querschnitts eines Drehschalters. Der Drehschalter weist eine Drehachse 9 auf, eine feste Magnetreihe 12 und eine drehbare Magnetreihe 13. Die Schaltringe 1 und Grundkörper 3 bestehen aus nicht ferromagnetischem Stoff. Die ferromagnetischen Stahlring 2 sind in den Schaltring 1 und Grundkörper 3 inkorporiert. Der Stoff wirkt aus Sicht des magnetischen Flusses 7 wie Luft und hält die Magnete 5 und den Detektor 4 mechanisch fest, ohne den magnetischen Fluss zu beeinflussen.

Die Reihe 13 kann der Reihe 12 gegenüber links oder rechts gedreht werden. Der in Figur 3 gezeigte Zustand korrespondiert mit dem in Figur 2 gezeigten Schaltzustand "Links" 16. Der Detektor des in Figur 3 dargestellten Drehschalters weist zwei Ausgangszustände auf, die den Schaltzuständen Links 16 und Rechts 17 entsprechen. Wenn der Drehschalter als Steuerelement eines Handgeräts, z.B. eines Schraubers oder Bohrers verwendet wird, dann könnten die zwei Zustände mit den zwei Drehrichtungen des Handgeräts korrespondieren.

Es besteht die Möglichkeit, den Detektor als Analogsensor zu betreiben, d.h die Magnete so anzuordnen, dass der Drehwinkel des Drehschalters erfasst werden kann. Der Detektorausgang wird dann als Analogsignal ausgewertet.

### Bezugszeichenliste

- 1.: Schaltring
- 2.: Ferromagnetische Stahlringe
- 3.: Grundkörper
- 4.: Magnetfelddetektor
- 5.: Magnete
- 6.: Drehrichtung
- 7.: Magnetischer Fluss
- 8.: Magnetpolung
- 9.: Drehachse
- 10.: Eingerasteter Zustand
- 11.: Magnetfeldsensor
- 12.: Magnetreihe (passiv)
- 13.: Magnetreihe (aktiv)
- 14.: Gegenüberliegende Seiten
- 15.: Abstand der Magnete
- 16.: Schaltzustand links
- 17.: Schaltzustand rechts
- 18.: Schaltende Magnete
- 19.: Eingerasteter Magnet
- 20.: Eingerasteter Magnet

## Patentansprüche

1. Schalteinheit mit kombinierter Schalt- und Rastfunktion zur Steuerung von Industriewerkzeugen, wobei sowohl die Rast**funktion auf magnetischer Basis erfolgt** und die Schalteinheit aus zwei gegenüberliegenden Reihen von Magneten (12, 13) besteht, wobei jede Reihe (12, 13) aus mindestens zwei Magneten (5) besteht und die Spaltbreite zwischen den sich gegenüberliegenden Seiten der Magnetreihen im Wesentlichen konstant ist, wobei die Reihen gegeneinander in Richtung der Reihenerstreckung (6) relativ beweglich sind, der Abstand zwischen den benachbarten Magneten einer Reihe (15) im Wesentlichen konstant ist, **dadurch gekennzeichnet, dass** die **Schaltfunktion auf magnetischer Basis erfolgt** und in mindestens einer der Reihen von Magneten mindestens ein Magnetfelddetektor (4, 11) vorgesehen ist.

2. Schalteinheit nach Anspruch 1, **dadurch gekennzeichnet, dass** der Detektor (4, 11) einen Magneten (5) einer Reihenfolge (12, 13) ersetzt und zwei benachbarte Magnete (5) aufweist.

3. Schalteinheit nach Anspruch 2, **dadurch gekennzeichnet, dass** der Detektor (4, 11) ein Hall-Effekt-Sensor ist.

4. Schalteinheit nach Anspruch 3, **dadurch gekennzeichnet, dass** der Abstand (15) zwischen dem Detektor (15) und jedem der zwei Magnete (5) näherungsweise dem Abstand oder einem ganzzähligen Vielfachen des Abstands zwischen den in der gegenüberliegenden Reihe (12, 13) montierten Magneten (5) entspricht, und wobei die dem Detektor (4, 11) benachbarten Magnete (5) so montiert sind, dass die sich gegenüberliegenden Seiten unterschiedliche Magnetpole (8) aufweisen.

5. Schalteinheit nach Anspruch 4, **dadurch gekennzeichnet, dass** die gegenüberliegenden Magnete (5) so angeordnet sind, dass die Schalteinheit zwei stabile eingerastete Zustände (16, 17) aufweist, wobei im eingerasteten Zustand (10) immer die sich gegenüberliegende Seite (14) eines Magnetes (18) dem Detektor (4, 11) direkt gegenüberliegt und vom Detektor (4,11) detektiert wird.

6. Schalteinheit nach Anspruch 5, **dadurch gekennzeichnet, dass** der Detektor (4, 11) zwei benachbarte Magnete (5) aufweist, und dass die dem Detektor gegenüberliegende Reihe von Magneten lediglich zwei Magnete aufweist, wobei die einander zugewandten Seiten der Magnete jeder Magnetreihe unterschiedlichen Magnetpolen entsprechen und die Abfolge der Magnetpole der beiden Reihen in Reihenerstreckung gesehen umgekehrt ist, so dass sich in jeder Raststellung zwei Magnete mit unterschiedlichen Polen gegenüberstehen und die Rastfunktion ausüben und in unterschiedlichen Raststellungen jeweils unterschiedliche Magnetpole den Detektoren gegenüberstehen.

7. Schalteinheit nach einem der vorhergehenden Ansprüche, **dadurch gekennzeichnet, dass** die Schalteinheit ein Drehschalter zum Einstellen der Drehrichtung (6) des Werkzeugs ist.

8. Schalteinheit nach einem der vorhergehenden Ansprüche, **dadurch gekennzeichnet, dass** die Reihen (12, 13) von Magneten (5) an ihren einander abgewandten Seiten mit einem ferromagnetischen Schild (2) versehen sind.

## Claims

1. Switching unit with a combined switching and latching function for controlling industrial tools, with both the latching function being performed on a magnetic basis and the switching unit comprising two opposite rows of magnets (12, 13), with each row (12, 13) comprising at least two magnets (5) and the gap width between the opposite sides of the rows of magnets being substantially constant, it being possible for the rows to be moved relative to one other in the direction of extent (6) of the rows, and the distance between the adjacent magnets of one row (15) being substantially constant, **characterized in that** the switching function is performed on a magnetic basis and at least one magnetic field detector (4, 11) is provided in at least one of the rows of magnets.

2. Switching unit according to Claim 1, **characterized in that** the detector (4, 11) replaces a magnet (5) of one row (12, 13) and has two adjacent magnets (5).

3. Switching unit according to Claim 2, **characterized in that** the detector (4, 11) is a Hall effect sensor.

4. Switching unit according to Claim 3, **characterized in that** the distance (15) between the detector (15) and each of the two magnets (5) corresponds approximately to the distance or an integer multiple of the distance between the magnets (5) which are fitted in the opposite row (12, 13), and with the magnets (5) which are adjacent to the detector (4, 11) being fitted such that the opposite sides have different magnetic poles (8) .

5. Switching unit according to Claim 4, **characterized in that** the opposite magnets (5) are arranged such that the switching unit has two stable latched-in states (16, 17), with the opposite side (14) of one magnet (18) always being directly opposite the detector (4, 11) and being detected by the detector (4, 11) in the latched-in state (10).

6. Switching unit according to Claim 5, **characterized in that** the detector (4, 11) has two adjacent magnets (5), and **in that** the row of magnets which is opposite the detector has only two magnets, with the facing sides of the magnets of each row of magnets corresponding to different magnetic poles and the order of the magnetic poles of the two rows being reversed as seen in the extent of the rows, and therefore, in each latching position, two magnets with different poles are situated opposite one another and execute the latching function and, in different latching positions, in each case different magnetic poles are situated opposite the detectors.

7. Switching unit according to one of the preceding claims, **characterized in that** the switching unit is a rotary switch for adjusting the direction (6) of rotation of the tool.

8. Switching unit according to one of the preceding claims, **characterized in that** the rows (12, 13) of magnets (5) are provided with a ferromagnetic plate (2) on their sides which are averted from one another.

## Revendications

1. Unité de commutation qui présente une fonction combinée de commutation et d'encliquetage pour commander des outils industriels,
la fonction d'encliquetage ayant lieu sur base magnétique et l'unité de commutation étant constituée de deux rangées opposées d'aimants (12, 13),
chaque rangée (12, 13) étant constituée d'au moins deux aimants (5) et la largeur de l'interstice entre les côtés opposés des séries d'aimants étant essentiellement constante,
les rangées pouvant se déplacer l'une par rapport à l'autre dans la direction de l'extension (6) des rangées,
la distance entre les aimants voisins d'une rangée (15) étant essentiellement constante,
**caractérisée en ce que**
la fonction de commutation a lieu sur base magnétique et
**en ce qu'**un détecteur (4, 11) de champ magnétique est prévu dans au moins l'une des rangées d'aimants.

2. Unité de commutation selon la revendication 1, **caractérisée en ce que** le détecteur (4, 11) remplace un aimant (5) d'une rangée (12, 13) et présente deux aimants (5) voisins.

3. Unité de commutation selon la revendication 2, **caractérisée en ce que** le détecteur (4, 11) est un détecteur à effet Hall.

4. Unité de commutation selon la revendication 3, **caractérisée en ce que** la distance (15) entre le détecteur (15) et chacun des deux aimants (5) correspond sensiblement à la distance ou à un multiple entier de la distance entre les aimants (5) montés dans la rangée (12, 13) opposée, les aimants (5) voisins du détecteur (4, 11) étant montés de telle sorte qu'ils présentent des pôles magnétiques (8) différents sur des côtés opposés.

5. Unité de commutation selon la revendication 4, **caractérisée en ce que** les aimants opposés (5) sont disposés de telle sorte que l'unité de commutation présente deux états encliquetés stables (16, 17), le côté opposé (14) d'un aimant (18) étant situé directement face au détecteur (4, 11) et étant détecté par le détecteur (4, 11) à l'état encliqueté (10).

6. Unité de commutation selon la revendication 5, **caractérisée en ce que** le détecteur (4, 11) présente deux aimants (5) voisins et **en ce que** la rangée d'aimants opposée au détecteur présente uniquement deux aimants, **en ce que** les côtés mutuellement opposés des aimants de chaque rangée d'aimants correspondent à des pôles magnétiques différents, **en ce que** la succession des pôles magnétiques des deux rangées est inversée dans l'extension de la rangée de telle sorte que dans chaque position d'encliquetage, deux aimants de pôles différents soient face à face et exercent la fonction d'encliquetage et que dans différentes positions d'encliquetage deux pôles magnétiques différents soient disposés face aux détecteurs.

7. Unité de commutation selon l'une des revendications précédentes, **caractérisée en ce que** l'unité de commutation est un commutateur rotatif destiné à établir le sens de rotation (6) de l'outil.

8. Unité de commutation selon l'une des revendications précédentes, **caractérisée en ce que** les rangées (12, 13) d'aimants (5) sont dotées d'un écran ferromagnétique (2) sur leurs côtés non tournés l'un vers l'autre.
